# EUROPÄISCHE PATENTANMELDUNG

(11) **EP 1 562 296 A2**
(43) Veröffentlichungstag der Anmeldung: **10.08.2005**
(21) Anmeldenummer: 05000674.1
(22) Anmeldetag: 14.01.2005
(51) Int. Cl.: H04B 1/08, B60R 11/02

(54) **Elektronisches Gerät zur Befestigung an einem Fahrzeugteil eines Fahrzeuges**

(30) Priorität: 05.02.2004 DE 102004005914
(71) Anmelder: Hirschmann Electronics GmbH & Co. KG, 72654 Neckartenzlingen (DE)
(72) Erfinder: Gelman, Alexander, 70736 Fellbach (DE)
(74) Vertreter: Thul, Hermann, Dipl.-Phys.

(57) **Zusammenfassung**

Elektronisches Gerät (1), wobei erfindungsgemäß vorgesehen ist, dass eine Erhebung (5) zwischen dem Gehäuse (2) oder der Leiterplatte (3) und dem Fahrzeugteil (4) sowie im Bereich der Erhebung (5) eine Öffnung vorgesehen ist und die Leiterplatte (3) ebenfalls eine Öffnung aufweist, wobei zur Befestigung und elektrischen Kontaktierung des elektronischen Gerätes (1) mit dem Fahrzeugteil (4) die Öffnungen in Überdeckung und die Leiterplatte direkt oder indirekt auf die Erhebung (5) bringbar sind und in diese ein Befestigungsmittel einsetzbar ist.

## Beschreibung

Die Erfindung betrifft ein elektronisches Gerät mit einem Gehäuse und einer Leiterplatte zur Befestigung an einem Fahrzeugteil eines Fahrzeuges gemäß den jeweiligen Merkmalen der Oberbegriffe der unabhängigen Patentansprüche.

Aus der DE 198 23 202 ist als ein elektronisches Gerät ein Antennenverstärker für ein Fahrzeug bekannt. Dieser Antennenverstärker weist eine Leiterplatte und ein Gehäuse auf, wobei die Leiterplatte entsprechend den Funktionen des Antennenverstärkers mit elektrischen, elektronischen und verbindenden Bauteilen (wie Steckverbinder, Kabel und dergleichen) bestückt ist. Zur Befestigung des Antennenverstärkers auf einer Fahrzeugscheibe wird ein komplex geformter Kunststoffrahmen auf die Fahrzeugscheibe geklebt und dann der Antennenverstärker in diesen Kunststoffrahmen eingeclipst, wobei das Gehäuse des Antennenverstärkers auf den Kunststoffrahmen exakt abgestimmt sein muß. Eine solche Ausgestaltung eines elektronischen Gerätes hat sich zwar bewährt, weist aber Nachteile auf, wenn der Antennenverstärker wegen eines Defektes oder wegen einer defekten Fahrzeugscheibe ausgetauscht werden muß. Außerdem ist der Nachteil gegeben, dass immer mindestens eine Steckverbindung zwischen einem Masseteil des Fahrzeuges und dem Antennenverstärker bei der Montage des Antennenverstärkers zusammengesteckt werden muß, um eine Masseverbindung, insbesondere zwecks Abschirmung herzustellen.

Der Erfindung liegt daher die Aufgabe zugrunde, ein elektronisches Gerät, insbesondere einen Antennenverstärker, für ein Fahrzeug bereitzustellen, mit dem die eingangs geschilderten Nachteile vermieden werden, so dass das elektronische Gerät einfach montierbar ist und gleichzeitig mit der Montage eine Masseverbindung hergestellt wird.

Diese Aufgabe ist durch die Merkmale der jeweiligen unabhängigen Patentansprüche gelöst.

Erfindungsgemäß ist einerseits vorgesehen, dass eine Erhebung zwischen dem Gehäuse oder der Leiterplatte und dem Fahrzeugteil sowie im Bereich der Erhebung eine Öffnung vorhanden ist und die Leiterplatte ebenfalls eine Öffnung aufweist, wobei zur Befestigung und elektrischen Kontaktierung des elektronischen Gerätes die Öffnungen in Überdekkung bringbar sind, die Leiterplatte direkt auf das Fahrzeugteil bringbar ist und in die Öffnungen ein Befestigungsmittel einsetzbar ist. Diese Anordnung und Befestigung hat hinsichtlich ihrer Konstruktion und der elektrischen Kontaktierung mehrere Vorteile. Zum einen sind die Öffnungen in dem Fahrzeugteil, welches aus einem elektrisch leitfähigen Material (z. B. Blech) besteht, und in der Leiterplatte, z. B. mittels Bohren, einfach einbringbar. Das Anzugsmoment des Befestigungsmittels bleibt in diesem Fall über die gesamte Betriebsdauer konstant, da beide Kontaktpartner aus steifen Werkstoffen bestehen. Es kann allerdings auch daran gedacht werden, die Höhe der zumindest einen Erhebung des Fahrzeugteiles so zu wählen, dass das Gehäuse des elektronischen Gerätes bündig auf dem Fahrzeugteil aufliegt. Je nach Einbausituation kann die Erhebung ein fester Bestandteil des Fahrzeugteiles sein und mit der Herstellung des Fahrzeugteiles zum Beispiel ausgeformt werden, wobei es auch denkbar ist, dass die Erhebung ein separates, zumindest teilweise elektrisch leitfähiges Bauteil ist. Besonders wichtig ist es bei dieser Konstruktion, dass das Fahrzeugteil aus einem elektrisch leitfähigen Material besteht und mittels der Anbringung der Leiterplatte im Bereich der Erhebung mittels der Befestigungsmittel, insbesondere einer Schraube, oder durch Auflage auf ein fahrzeugseitig vorhandenes Befestigungsmittel , z. B. einen Bolzen mit anschließendem Einsetzen einer Mutter, eine elektrische Kontaktierung zwischen der Leiterplatte und dem Fahrzeugteil hergestellt wird, wozu zum Beispiel um die Öffnung in der Leiterplatte herum ein elektrisch leitfähiger Bereich (Leiterbahn) vorgesehen ist, der bei Auflage dieses Bereiches auf der Erhebung und der anschließenden Befestigung, zum Beispiel mittels der Schraube, die elektrische Kontaktierung (insbesondere Masseverbindung) herstellt. Besteht die Erhebung aus Metall (separates Bauteil oder Ausformung in dem Fahrzeugteil) ist der weitere Vorteil gegeben, dass die elektrische Verbindung während der Lebensdauer des elektronischen Gerätes zuverlässig bestehen bleibt, da sich diese Bereiche der Kontaktierung nicht verformen können. Die Befestigung mittels einer Schraube kann einfach und schnell ausgeführt werden, wodurch nach Beendigung des Schraubvorganges automatisch die Masseverbindung hergestellt worden ist, ohne dass es zusätzlicher Bauteile (wie Kabel, Steckverbinder und dergleichen, die eine Fehlerquelle bei der Kontaktierung darstellen) bedürfte.

In besonders vorteilhafter Weise ist die Öffnung in der Leiterplatte in einem Bereich der Leiterplatte angeordnet, die aus dem Gehäuse des elektronischen Gerätes herausragt. Durch eine solche aus dem Gehäuse herausragende Lasche, die von der Leiterplatte gebildet wird, ist der Vorteil gegeben, dass das elektronische Gerät mit Leiterplatte, Bauteilen und Gehäuse fertig bestückt und geprüft werden kann, wobei nach Bestückung und Prüfung das elektronische Gerät nur noch im Bereich der Lasche mit der Erhebung des Fahrzeugteiles verschraubt werden muß, so dass mittels der Verschraubung gleichzeitig die Befestigung und die elektrische Kontaktierung durchgeführt wird. Alternativ dazu ist es auch denkbar, dass die zumindest eine Öffnung in der Leiterplatte innerhalb des Gehäuses angeordnet ist. Auch in diesem Fall wird die Leiterplatte und dadurch das elektronische Gerät an der zumindest einen Erhebung des Fahrzeugteiles befestigt und gleichzeitig kontaktiert. Bei einer weiteren Ausführungsvariante kann als Erhebung die Auflagefläche eines Schweißbolzens oder einer Schweißschraube dienen. In diesem Fall kann das Fahrzeugteil im Bereich der Befestigung flächig gestaltet werden.

Des Weiteren können die Öffnungen rund, insbesondere zum Toleranzausgleich länglich ausgeführt werden oder auch andere Formen aufweisen.

Bei einer einfachen Variante ist die Schraube zum Selbstformen eines Gewindes ausgebildet, wobei mit Eindrehen der gewindeformenden (z.B. gewindeschneidenden oder gewindefurchenden) Schraube in die Öffnung in der Erhebung ein Gewinde geformt wird. Alternativ dazu ist es denkbar, dass die Erhebung nach ihrer Herstellung mit einem Gewinde zur Aufnahme der Schraube versehen wird (z.B. durch Einpressen oder Schweißen eines entsprechenden Gewindeträgers). Alternativ zu einer Schraubverbindung sind auch andere Verbindungen (wie z. B. Clipsverbindungen) denkbar, wobei allerdings die Schraubverbindung gerade mit Blick auf die elektrische Kontaktierung und die dafür erforderlichen hohen Andruckkräfte die bessere Wahl darstellt.

Erfindungsgemäß ist andererseits vorgesehen, dass das elektronische Gerät neben zumindest einem Befestigungsmittel für die Endmontage zumindest ein weiteres Befestigungsmittel zur Vormontage des elektronischen Gerätes an dem Fahrzeugteil aufweist. Ein solches weiteres Befestigungsmittel, welches beispielsweise als ein Clipselement ausgebildet ist, hat den Vorteil, dass das vormontierte und geprüfte elektronische Gerät zur Vormontage an dem Fahrzeugteil befestigt wird, ohne dass damit eine elektrische Kontaktierung einher geht. Ein solches weiteres Befestigungsmittel wird insbesondere dann benötigt, wenn das elektronische Gerät über Kopf montiert wird, so dass das elektronische Gerät in eine Vormontageposition gebracht wird und nicht herunterfallen kann. Anschließend können die Öffnungen in der Leiterplatte und in der Erhebung in Überdeckung gebracht und das Befestigungsmittel eingesetzt und angezogen werden. Damit ist eine wesentliche Vereinfachung der Montage des elektronischen Gerätes gegeben, so dass der Monteur zunächst das elektronische Gerät in seine Vormontageposition bringen kann und anschließend beide Hände zum Einsetzen beispielsweise der Schraube und dem anschließenden Festziehen der Schraube zur Verfügung hat, ohne das elektronische Gerät in seiner Endmontageposition noch festhalten zu müssen.

Ein Ausführungsbeispiel der Erfindung, auf das diese jedoch nicht beschränkt ist, ist im folgenden beschrieben und anhand der Figuren erläutert.

Es zeigen:
- Figur 1: Schnitt durch ein elektronisches Gerät in seiner Endmontageposition,
- Figur 2: Draufsicht auf das elektronische Gerät,
- Figuren 3 bis 7: alternative Ausgestaltung eines elektronischen Gerätes und dessen Montageschritte.
- Figuren 8 bis 11: weitere alternative Ausgestaltung eines elektronischen Gerätes und dessen Montageschritte.

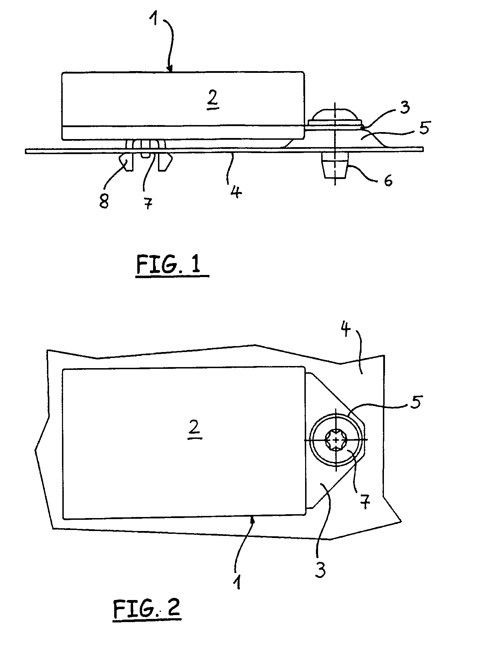

In der Figur 1 ist mit der Bezugsziffer 1 ein elektronisches Gerät, insbesondere ein Antennensverstärker, für ein Fahrzeug gezeigt. Dieses elektronische Gerät 1 weist ein Gehäuse 2 zum Beispiel aus Kunststoff auf. Innerhalb des elektronsichen Gerätes 1 ist eine Leiterplatte 3 vorhanden, die mit elektrischen, elektronischen und verbindenden Bauteilen entsprechend der Funktion des elektronischen Gerätes 1 bestückt ist. Nicht dargestellt, aber in Abhängigkeit des Einsatzzweckes des elektronischen Gerätes 1 sind noch Kabel, Steckverbinder oder dergleichen vorhanden. Bei dem in Figur 1 gezeigten elektronischen Gerät 1 ist die innerhalb des Gehäuses 2 angeordnete Leiterplatte in Form einer Lasche aus dem Gehäuse 2 herausgeführt und insgesamt mit der Bezugsziffer 3 bezeichnet. Im Bereich dieser Lasche ist in der Leiterplatte 3 eine nicht näher bezeichnete Öffnung vorhanden.

Zur Anbringung des elektronischen Gerätes 1 an einem Fahrzeugteil 4, wie zum Beispiel einem Karosseriebauteil aus Blech, wird dieses Fahrzeugteil 4 mit einer Erhebung 5 bei seiner Herstellung versehen oder die Erhebung 5 nachträglich in Form eines elektrisch leitfähigen Bauteiles angebracht. Im Bereich der Erhebung 5 ist eine ebenfalls nicht näher bezeichnete Öffnung vorhanden. Zur Befestigung des elektronischen Gerätes 1 an dem Fahrzeugteil 4 wird nun in die Öffnungen der Leiterplatte 3 und der Erhebung 5 eine Schraube 7 eingedreht, wodurch mit diesem Befestigungsmittel einerseits das elektronische Gerät 1 an dem Fahrzeugteil 4 befestigt und andererseits gleichzeitig eine elektrische Kontaktierung (insbesondere Masseverbindung) zwischen dem elektronischen Gerät 1 und dem Fahrzeugteil 4 erfolgt. Dazu weisen die Leiterplatte 3 und die Erhebung 5 im Bereich um die Schraube 6 herum einander zugewandte und weitestgehend flächengleiche Kontaktstellen auf.

Zur Vormontage des elektronischen Gerätes 1, dass heißt vor dem Eindrehen der Schraube 6, wird in eine Öffnung 7 des Fahrzeugteiles 4 ein Clipselement 8, welches an der Leiterplatte 3 oder dem Gehäuse 1 befestigt ist oder befestigbar ist, eingesetzt, um somit das elektronische Gerät 1 in einer Formmontageposition an dem Fahrzeugteil 4 festzulegen. Anschließend können, falls dies nicht schon der Fall ist, die Öffnungen in der Leiterplatte 3 und der Erhebung 5 in Überdeckung gebracht und die Schraube 6 eingedreht werden.

Figur 2 zeigt das an dem Fahrzeugteil 4 montierte elektronische Gerät 1 in der Draufsicht, wobei noch einmal deutlich zu erkennen ist, dass die Leiterplatte 3 in Form einer Lasche aus dem Gehäuse 2 herausgeführt ist. Alternativ dazu kann die Leiterplatte 3 vollständig von dem Gehäuse 2 umgeben sein, wobei auch in diesem Fall entsprechende Öffnung in der Leiterplatte 3 mit der fahrzeugseitig vorgesehener Öffnung einer Erhebung in Überdeckung bringbar ist, so daß anschließend das Gerät 1 mit dem Fahrzeugteil 4 verbunden werden kann.

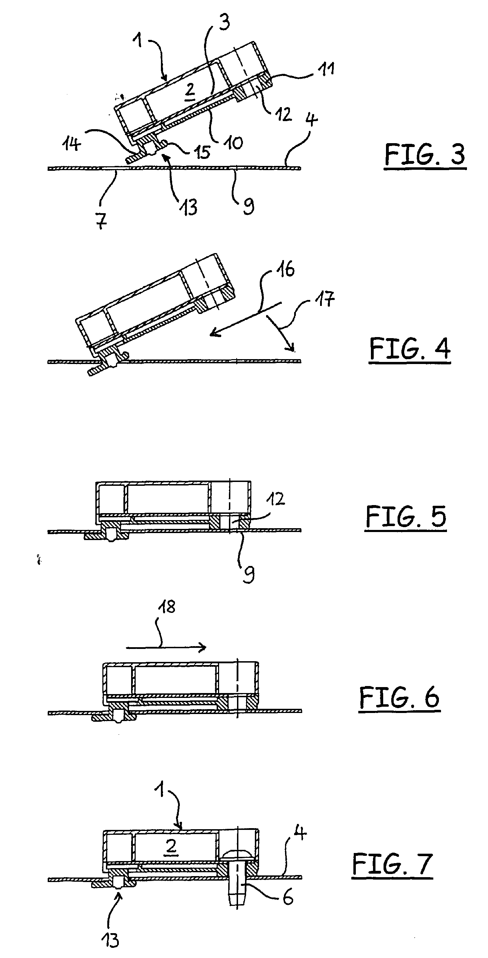

In den Figuren 3 bis 7 ist eine alternative Ausgestaltung des elektronischen Gerätes 1 und dessen Montageschritte gezeigt, wobei bei dieser Ausführung das elektronische Gerät 1 neben zumindest einem Befestigungsmittel für die Endmontage zumindest ein weiteres Befestigungsmittel zur Vormontage des elektronischen Gerätes an dem Fahrzeugteil aufweist. Diese Ausgestaltung, genauso wie das Clipselement 8 gemäß Figur 1, hat den Vorteil, dass das elektronische Gerät 1 einfach und vor allen Dingen über Kopf an dem Fahrzeugteil, beispielsweise im Dachbereich oder einer Säule, in eine Vormontageposition gebracht werden kann, so dass dem Monteur anschließend beide Hände zum Einsetzen und Anziehen des Befestigungsmittels für die Endmontage zur Verfügung stehen.

Im einzelnen weist das elektronische Gerät 1 wieder das Gehäuse 2 auf, in dem die Leiterplatte 3 angeordnet ist, wobei auch bei dieser Ausführungsform die Leiterplatte 3 aus dem Gehäuse 2 herausragen kann. Das Fahrzeugteil 4 weist neben der Öffnung 7 für das Befestigungsmittel zur Vormontage auch eine Öffnung 9 auf, die in den Figuren 1 und 2 auch vorhanden, aber nicht mit einer Bezugsziffer versehen ist. Bei der Ausgestaltung des elektronischen Gerätes 1 gemäß den Figuren 3 bis 7 ist eine Grundplatte bzw. Gehäuseunterteil 10 vorhanden, die sowohl aus einem elektrisch leitfähigen als auch aus einem elektrisch nicht leitfähigen Material bestehen kann. Diese Grundplatte bzw. Gehäuseunterteil 10 ist an ihrer einen Seite (oder auch in einem Zwischenbereich) mit einer Erhebung 11 (Verdickung) versehen, in der eine Öffnung 12 für das Befestigungsmittel für die Endmontage vorgesehen ist. Auf der der Erhebung 11 abgewandten Seite der Grundplatte 10 ist ein etwa ┴- förmiger Fuß 13 vorgesehen, der integraler Bestandteil der Grundplatte bzw. des Gehäuseunterteils 10 ist. Wenn keine Grundplatte bzw. Gehäuseunterteil 10 vorhanden ist, an der das Gehäuse bzw. Gehäuseoberteil 2 des elektronischen Gerätes 1 anzubringen ist, kann dieser Fuß 13 auch direkt an der Leiterplatte 3 oder in besonders vorteilhafter Weise an dem Gehäuse 2 des elektronischen Gerätes 1 angebracht werden. Der Fuß 13 weist insbesondere einen etwas längeren Vorsprung 14 und einen kürzeren Vorsprung 15 auf, wobei die Länge und Ausgestaltung (Form) der Vorsprünge 14, 15 von der Montageabfolge und der Form und den Abmessungen der Öffnung 7 abhängen.

Figur 3 zeigt das elektronische Gerät 1 vor dem Beginn seiner Montage im Fahrzeug. In Figur 4 ist gezeigt, dass das elektronische Gerät 1 mit dem Fuß 13, das heißt mit dem längeren Vorsprung 14 voran, schräg zum Fahrzeugteil 4 in einer Linearbewegung 16 in die Öffnung 7 eingesetzt wird. Nach dem Einsetzen ist es aufgrund der Abmessungen der Öffnung 7 und der Länge des kürzeren Vorsprunges 15 möglich, das elektronische Gerät 1 in einer Drehbewegung 17 in etwa parallel zu dem Fahrzeugteil 4 auszurichten, insbesondere soweit, bis die Unterseite der Erhebung 11 auf dem Fahrzeugteil 4 zur Auflage kommt. Diese Position ist in Figur 5 gezeigt, wobei hier darauf hinzuweisen ist, dass die Öffnung 12 in der Erhebung 11 noch nicht deckungsgleich mit der Öffnung 9 in dem Fahrzeugteil 4 ist. Die Überdeckung der beiden Öffnungen 9, 12, die erforderlich ist, um dort das Befestigungsmittel für die Endmontage einsetzen zu können, wird durch eine Linearbewegung 18, das heißt ein Verschieben des elektronischen Gerätes 1 relativ zu dem Fahrzeugteil 4, erzielt. Diese Linearbewegung 18 ist in Figur 6 gezeigt, so dass dadurch eine Deckungsgleichheit der beiden Öffnungen 9, 12 hergestellt wird. Diese Deckungsgleichheit der beiden Öffnungen 9, 12 ermöglicht es, dass als Befestigungsmittel für die Endmontage die Schraube 6 eingesetzt werden kann, die dann das elektronische Gerät 1 (genauer das Gehäuse 2 und die Leiterplatte 3) über die Erhebung 11 mit dem Fahrzeugteil 4 verbindet, wobei in besonders vorteilhafter Weise auch eine elektrische Verbindung zwischen der Leiterplatte 3 und dem Fahrzeugteil 4 erzielt werden kann.

Alternative Ausgestaltungen zu der in den Figuren 3 bis 7 gezeigten Konstruktion und der Montagefolge ist es denkbar, dass der Fuß 13 direkt an dem Gehäuse 2 oder der Leiterplatte 3 angeordnet ist und das Fahrzeugteil 4 die Erhebung aufweist, so dass eine Grundplatte bzw. Gehäuseunterteil entfallen kann. Ebenso ist es denkbar, dass die Grundplatte 10, wenn eine solche zum Einsatz kommt, ein- oder mehrteilig ausgebildet ist. Ebenso können Grundplatte bzw. Gehäuseunterteil 10 und Gehäuse bzw. Gehäuseoberteil 2 eine Einheit bilden, wobei die Leiterplatte 3 in dieses Gehäuse 2 eingesetzt und anschließend mit einem Deckel versehen wird. Das Gehäuse 2 seinerseits besteht aus einem elektrisch nicht leitfähigen Material, wie beispielsweise Kunststoff und kann unlösbar oder in besonders vorteilhafter Weise lösbar, zum Beispiel mittels einer Clipsverbindung bzw. Verrastung, mit der Grundplatte 10 und/oder der Leiterplatte 2 verbunden werden. Des weiteren können Grundplatte bzw. Gehäuseunterteil 10 und Gehäuse bzw. Gehäuseoberteil 2 ein zusammenklappbares Teil bilden, in welches die Leiterplatte eingesetzt wird.

Figur 7 zeigt bei dieser Ausführungsform, dass mittels des Fußes 13 das elektronische Gerät 1 in eine Vormontageposition gebracht werden kann und mittels der Schraube 6 eine elektrische Kontaktierung zwischen dem elektronischen Gerät 1 und dem Fahrzeugteil 4 erzielt wird. Daneben bieten sich aber auch die Möglichkeiten an, mittels beispielsweise der Schraube 6 nur eine Befestigung und keine elektrische Kontaktierung vorzunehmen, genauso wie mittels des Fußes 13 nur eine Befestigung für die Vormontageposition oder auch eine elektrische Kontaktierung erzielt werden kann. Die in den vorangegangenen Figuren gezeigten verschiedenen Ausführungsformen haben alle den Vorteil, dass das elektronische Gerät 1 nach seiner Endmontage, insbesondere im Fehlerfalle, auch wieder demontiert werden kann. Ist dies nicht beabsichtigt, können die Befestigungsmittel für die Vormontage und/oder die Endmontage auch als unlösbare Befestigungsmittel (wie zum Beispiel Klebeverbindungen) ausgebildet werden, die den gleichen Zweck erfüllen, wie die in den vorangegangen Figuren gezeigten und beschriebenen Befestigungsmittel.

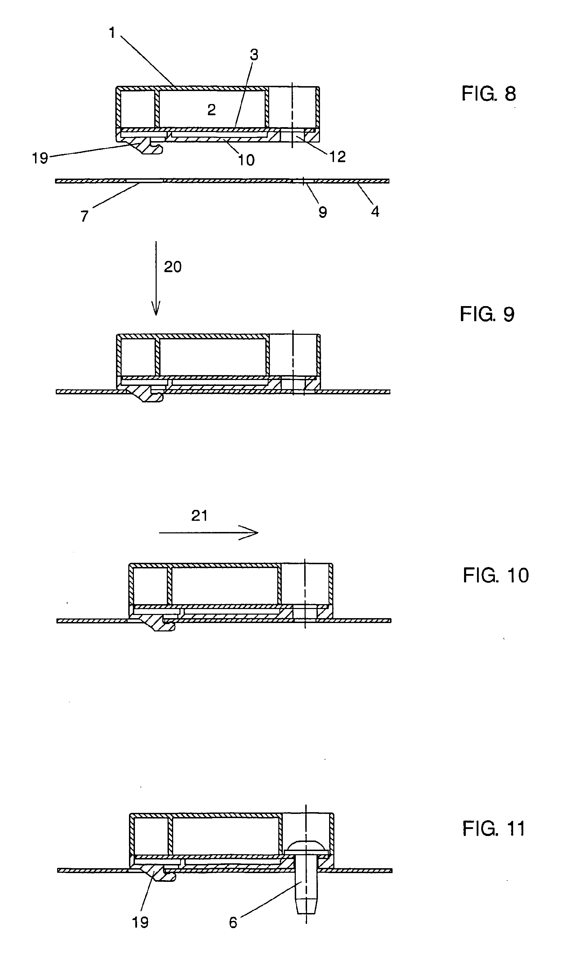

In den Figuren 8 bis 11 ist eine weitere alternative Ausgestaltung des elektronischen Gerätes 1 und dessen Montageschritte gezeigt, wobei auf der den Öffnungen 9, 12 abgewandten Seite der Grundplatte bzw. des Gehäuseunterteils 10 ein etwa L- förmiger Fuß 19 vorgesehen ist, der integraler Bestandteil der Grundplatte bzw. des Gehäuseunterteils 10 ist. Wenn keine Grundplatte bzw. Gehäuseunterteil 10 vorhanden ist, an der das Gehäuse bzw. Gehäuseoberteil 2 des elektronischen Gerätes 1 anzubringen ist, kann dieser Fuß 19 auch direkt an der Leiterplatte 3 oder in besonders vorteilhafter Weise an dem Gehäuse 2 des elektronischen Gerätes 1 angebracht werden. Der Fuß 19 weist einen hier nicht gesondert gekennzeichneten Vorsprung auf, wobei die Länge und Ausgestaltung (Form) dieses Vorsprungs und des Fußes insgesamt von der Form und den Abmessungen der Öffnung 7 abhängen.

Bei der in Figuren 8 bis 11 gezeigten Konstruktion sind die in Bezug auf die Figuren 3 bis 7 beschriebenen alternativen Gestaltungsmöglichkeiten ebenfalls möglich.

Figur 8 zeigt das elektronische Gerät 1 vor dem Beginn seiner Montage im Fahrzeug. In Figur 9 ist gezeigt, dass das elektronische Gerät 1 mit dem Fuß 19 in die Öffnung 7 durch eine Linearbewegung 20 eingesetzt wird. Nach dem Einsetzen ist das elektronische Gerät 1 in etwa parallel zu dem Fahrzeugteil 4 ausgerichtet, wobei die Unterseite der Erhebung 11 auf dem Fahrzeugteil 4 zur Auflage kommt. Hier ist darauf hinzuweisen, dass die Öffnung 12 in der Erhebung 11 noch nicht deckungsgleich mit der Öffnung 9 in dem Fahrzeugteil 4 ist. Die Überdeckung der beiden Öffnungen 9, 12, die erforderlich ist, um dort das Befestigungsmittel für die Endmontage einsetzen zu können, wird durch eine Linearbewegung 21, das heißt ein Verschieben des elektronischen Gerätes 1 relativ zu dem Fahrzeugteil 4, erzielt. Diese Linearbewegung 21 ist in Figur 10 gezeigt, so dass dadurch eine Deckungsgleichheit der beiden Öffnungen 9, 12 hergestellt wird. Diese Deckungsgleichheit der beiden Öffnungen 9, 12 ermöglicht es, dass als Befestigungsmittel für die Endmontage die Schraube 6 eingesetzt werden kann, die dann das elektronische Gerät 1 (genauer das Gehäuse 2 und die Leiterplatte 3) über die Erhebung 11 mit dem Fahrzeugteil 4 verbindet, wobei in besonders vorteilhafter Weise auch eine elektrische Verbindung zwischen der Leiterplatte 3 und dem Fahrzeugteil 4 erzielt werden kann.

Abschließend sei noch darauf hingewiesen, dass, obwohl nur eine Befestigungs- und Kontaktierungsstelle gezeigt worden ist, auch mehr als eine solcher Stellen vorhanden sein können.

### Bezugszeichenliste

- 1: Elektronisches Gerät
- 2: Gehäuse
- 3: Leiterplatte
- 4: Fahrzeugteil
- 5: Erhebung
- 6: Schraube
- 7: Öffnung
- 8: Clipselement
- 9: Öffnung
- 10: Grundplatte
- 11: Erhebung
- 12: Öffnung
- 13: ┴-förmiger Fuß
- 14: Langer Vorsprung
- 15: Kurzer Vorsprung
- 16: Linearbewegung
- 17: Drehbewegung
- 18: Linearbewegung
- 19: L- förmiger Fuß
- 20: Linearbewegung
- 21: Linearbewegung

## Patentansprüche

1. Elektronisches Gerät (1), **dadurch gekennzeichnet, dass** eine Erhebung (5) zwischen dem Gehäuse (2) oder der Leiterplatte (3) und dem Fahrzeugteil (4) sowie im Bereich der Erhebung (5) eine Öffnung vorgesehen ist und die Leiterplatte (3) ebenfalls eine Öffnung aufweist, wobei zur Befestigung und elektrischen Kontaktierung des elektronischen Gerätes (1) mit dem Fahrzeugteil (4) die Öffnungen in Überdeckung und die Leiterplatte direkt oder indirekt auf die Erhebung (5) bringbar sind und in diese ein Befestigungsmittel einsetzbar ist.

2. Elektronisches Gerät (1) mit einem Gehäuse (2) und einer Leiterplatte (3), die entsprechend der Funktionen des elektronischen Gerätes (1) mit elektrischen, elektronischen und verbindenden Bauteilen bestückt ist, wobei das elektronische Gerät (1) an einem Fahrzeugteil (4) eines Fahrzeuges befestigbar ist, **dadurch gekennzeichnet, dass** das elektronische Gerät (1) neben zumindest einem Befestigungsmittel für die Endomontage zumindest ein weiteres Befestigungsmittel zur Vormontage des elektronischen Gerätes (1) an dem Fahrzeugteil (4) aufweist.

3. Elektronisches Gerät (1) nach Anspruch 1 oder 2, **dadurch gekennzeichnet, dass** die Erhebung (5) ein Bestandteil des Fahrzeugteiles (4) ist.

4. Elektronisches Gerät (1) nach Anspruch 1 oder 2, **dadurch gekennzeichnet, dass** die Erhebung (5) ein separates, zumindest teilweise elektrisch leitfähiges Bauteil ist.

5. Elektronisches Gerät (1) nach Anspruch 2, **dadurch gekennzeichnet, dass** das weitere Befestigungsmittel für die Vormontage zumindest ein Clipselement (8) ist, welches in einer korrespondierenden Öffnung (7) in dem Fahrzeugteil (4) einsetzbar ist.

6. Elektronisches Gerät (1) nach einem oder mehreren der Ansprüche 2 bis 5, **dadurch gekennzeichnet, dass** das Gehäuse (2) oder eine mit dem Gehäuse (2) verbindbare Grundplatte bzw. Gehäuseunterteil (10) einen in etwa ┴-förmigen Fuß (13) aufweist, der als weiteres Befestigungsmittel für die Vormontage in eine Öffnung (7) des Fahrzeugteiles (4) mittels einer Linear-, Dreh- und folgend einer Linearbewegung (16, 17, 18) einsetzbar ist.

7. Elektronisches Gerät (1) nach einem oder mehreren der Ansprüche 2 bis 5, **dadurch gekennzeichnet, dass** das Gehäuse (2) oder eine mit dem Gehäuse (2) verbindbare Grundplatte bzw. Gehäuseunterteil (10) einen in etwa L- förmigen Fuß (19) aufweist, der als weiteres Befestigungsmittel für die Vormontage in eine Öffnung (7) des Fahrzeugteiles (4) mittels zwei aneinander folgenden Linearbewegungen (20, 21) einsetzbar ist.

8. Elektronisches Gerät (1) nach einem oder mehreren der vorhergehenden Ansprüche, **dadurch gekennzeichnet, dass** das Befestigungsmittel eine Schraube oder ein Bolzen ist.

9. Elektronisches Gerät (1) nach einem oder mehreren der vorhergehenden Ansprüche, **dadurch gekennzeichnet, dass** die Erhebung (5) ein Gewinde zur Aufnahme der Schraube aufweist.

10. Elektronisches Gerät (1) nach einem der vorhergehenden Ansprüche, **dadurch gekennzeichnet, dass** die Leiterplatte (3) mit dem Bereich, in dem die Öffnung zum Einsetzen des Befestigungsmittels eingebracht ist, aus dem Gehäuse (2) herausragt.
